(19) **Europäisches Patentamt**
**European Patent Office**
**Office européen des brevets**

(11) **EP 3 455 640 B1**

(12) **EUROPÄISCHE PATENTSCHRIFT**

(45) Veröffentlichungstag und Bekanntmachung des Hinweises auf die Patenterteilung:
**01.04.2020 Patentblatt 2020/14**

(21) Anmeldenummer: **17723988.6**

(22) Anmeldetag: **15.05.2017**

(51) Int Cl.:
*G01R 29/08* (2006.01)   *G01R 29/10* (2006.01)

(86) Internationale Anmeldenummer:
**PCT/EP2017/061606**

(87) Internationale Veröffentlichungsnummer:
**WO 2017/198613 (23.11.2017 Gazette 2017/47)**

(54) **ANTENNENMESSKAMMER**

ANTENNA TEST CHAMBER

CHAMBRE DE MESURE D'ANTENNES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.05.2016 DE 102016005939**

(43) Veröffentlichungstag der Anmeldung:
**20.03.2019 Patentblatt 2019/12**

(73) Patentinhaber: **HENSOLDT Sensors GmbH 82024 Taufkirchen (DE)**

(72) Erfinder:
- **LORCH, Ralf 89275 Elchingen (DE)**
- **WALSER, Stephan 89250 Senden (DE)**

(74) Vertreter: **LifeTech IP Spies & Behrndt Patentanwälte PartG mbB Elsenheimerstraße 47a 80687 München (DE)**

(56) Entgegenhaltungen:
KR-B1- 100 987 035      US-A- 5 532 704
US-A1- 2006 261 821      US-A1- 2013 284 876

- **M.J. Alexander ET AL: "A NATIONAL MEASUREMENT GOOD PRACTICE GUIDE NO. 73 Calibration and use of antennas, focusing on EMC applications", , 31. Dezember 2004 (2004-12-31), XP055385536, Gefunden im Internet: URL:https://www.wmo.int/pages/prog/gcos/documents/gruanmanuals/UK_NPL/mgpg73.pdf [gefunden am 2017-06-27]**
- **Martin Rowe: "Anechoic chambers rise from the pits", , 31. Dezember 2009 (2009-12-31), Seiten 1-5, XP055385831, Gefunden im Internet: URL:http://www.edn.com/design/test-and-measurement/4387708/Anechoic-chambers-rise-from-the-pits-4387708 [gefunden am 2017-06-28]**

**Beschreibung**

Die Erfindung bezeichnet eine Antennenmesskammer für den HF-Bereich mit variabler Antennenentfernung zur Vermessung von Antenneneigenschaften.

Aus der EMV-Prüftechnik (EMV: Elektromagnetische Verträglichkeit) sind Messkammern bekannt, mit denen insbesondere eine Störfestigkeitsprüfung und Störaussendungsmessungen durchgeführt werden. Diese Messkammern sind derart ausgestattet, dass Messungen in einer von der Umwelt abgeschlossenen und elektromagnetisch getrennten Prüf- und Messumgebung durchgeführt werden können. Dabei können sowohl Störfestigkeitsprüfungen hoher Feldstärke als auch Messungen elektromagnetischer Feldaussendungen sehr geringer Pegel ausgeführt werden.

In der Radartechnik wird diese vor allem zur Vermessung von Antennen und damit zur Bildung der Antennendiagramme eingesetzt. Insbesondere können die Messungen ohne rechtliche Beschränkungen, wie z. B. eine beschränkte Freigabe bestimmter Frequenzen, ausgeführt werden, nachdem keine Aussendung von Strahlung und somit Störung von vorhandenen Funkdiensten in der Umgebung der Messeinrichtung erfolgt.

Alternative Prüfumgebungen, z. B. TEM-Zellen und GTEM-Zellen, sind häufig so klein und kompakt gebaut, dass diese nur sehr kleine Antennen oder kleineste elektronische Bauteile vermessen lassen und zudem nicht begehbar sind, um z.B. das Prüfobjekt während eines Störfestigkeitstests zu beobachten. Somit sind diese für die Radartechnik als ungeeignet anzusehen.

Eine Antennenmesskammer weist metallisch und elektrisch gut leitfähige Wände auf, welche den Innenraum der Kammer elektromagnetisch von der Außenwelt abschirmen. Dabei werden ja nach Ausführung Schirmraten von etwa 60 dB bis 90 dB und darüber hinaus erreicht, wobei besonderes Augenmerk der Messkammer auf die Öffnungen hinsichtlich Zu- und Ableitungen für die Belüftung, Beleuchtung, elektrische Leitungsführung des Testequipments und die Türen zu richten ist, damit ein störungsfreies Umfeld und eine HF-dichte Kammer entsteht. Problematisch sind hierbei ungewollte Schlitzantennen, die sich an Spalten zwischen Innen- und Außenbereich ergeben.

Die innenliegenden Begrenzungsflächen der Messkammer sind mit Absorbern ausgekleidet, welche die im Inneren erzeugte Feldenergie durch Absorption in Wärmeenergie umsetzen. Die Absorber verhindern das Auftreten von Reflexionen, so dass annähernd ein Verhalten wie im Freiraum erzielt wird.
Absorber werden häufig mehrstufig aufgebaut, wobei z. B. als unterste Schicht Platten aus weichmagnetischen Ferriten angebracht sind, welche Frequenzanteile im Bereich bis einige 100 MHz gut absorbieren. Darüber werden die typischen und bekannten Pyramiden in regelmäßiger Struktur aus geschäumten Kunststoffen wie Polyurethane mit großem Verlustwinkel, bei Bedarf mit im Kunststoff zusätzlich eingebrachten Ferritpartikeln, angebracht, wobei diese primär niedrige Frequenzanteile absorbieren.

Unterschieden werden Messkammern mit vollständiger oder teilweiser Auskleidung mit Absorbern. Man spricht dann von vollständigen und Semi-Absorberkammern. Bei vollständigen Absorberkammern sind alle Flächen, insbesondere auch der Boden, mit HF-Absorbern ausgekleidet. Zur Einbringung der Messobjekte, der diversen Halterungen und der Antennen oder Änderungen des Aufbaus müssen die Absorber aufwendig am Boden zumindest teilweise entfernt und vor einer Messung wieder am Boden angebracht werden.
Bei Semi-Absorberkammern sind nur die Seitenwände und die Decke mit Absorbern ausgestattet. Der Boden ist mit gut leitfähigen und elektrisch untereinander verbundenen massiven Metallplatten ausgeführt, die direkt begehbar oder befahrbar sind. Somit können fahrbare Masten mit Antennen auf dem freien Boden eingesetzt werden. Der Boden in Semi-Absorberkammern ist durch die Metallplatten stark reflektiv und entspricht in Näherung einer Freifeldanordnung auf der Erdoberfläche, wobei der Erdboden reflektiv wirkt.

Grundsätzlich sind bei der Durchführung einer Messung innerhalb der Messkammer die zu prüfende Antenne (AUT- Antenna Under Test) sowie als Gegenstelle eine weitere Antenne, die sogenannte Messantenne vorhanden. Aufgrund des frequenzabhängigen Ausbreitungs- und Absorptionsverhaltens der HF-Strahlung ergeben sich für tiefe und hohe Frequenzen gegensätzliche Forderungen bezüglich des Abstands zwischen AUT und Messantenne.

Für hohe Messfrequenzen sind z.B. bei Gruppenantennen vergleichsweise große Entfernungen zwischen Messantenne und zu testender Antenne erforderlich.
Im Folgenden wird als AUT von einer Empfangsantenne ausgegangen, die erforderliche Gegenstelle (Messantenne) ist damit eine Sendeantenne. Alle Ausführungen gelten auch für Sendeantennen mit einer Empfangsantenne als Gegenstelle.

Der oben erwähnte Zusammenhang zwischen dem Abstand Sendeantenne/AUT und der Frequenz folgt aus der Beziehung für den Fernfeldradius, $r_F$, der bei diesen Messungen mindestens einzuhalten ist.

$$r_F = \frac{2 \times D^2}{\lambda};$$

Dabei ist:

- D die größte Antennendimension (d.h. Länge der Apertur / Durchmesser bei runder Antenne),
- $\lambda$ die Wellenlänge.

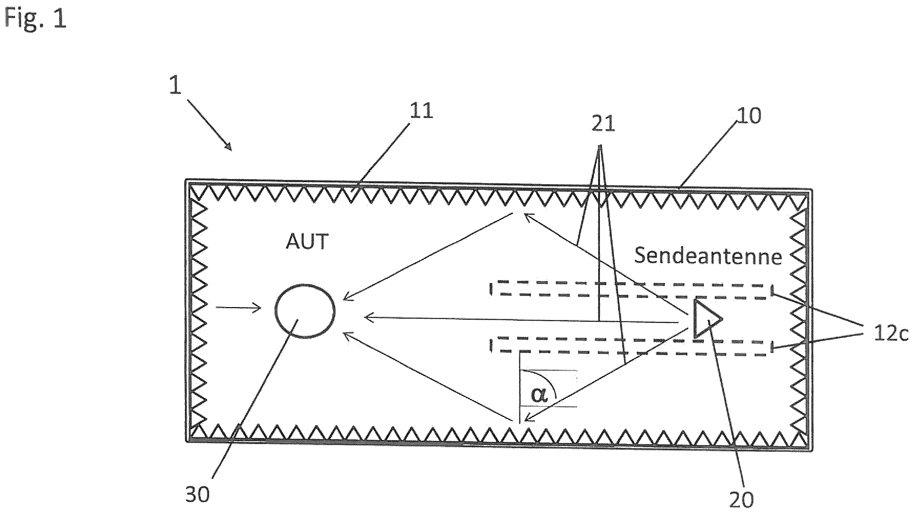

Darüber hinaus vergrößert das Erhöhen der Entfernung zwischen Sendeantenne und AUT den Reflektionswinkel $\alpha$ wie aus Fig. 1 abgeleitet werden kann.

Sie zeigt eine Antennenmesskammer 1 mit rechtwinkligem Grundriss, sowie mit der AUT 30 und Sendeantenne 20. Ein vergrößerter Reflektionswinkel α reduziert prinzipiell die Dämpfung unerwünschter Wellen, da die Absorber an den Wänden bei senkrechten Signaleinfall (d. h. α = 0°) optimal arbeiten. Da die Performance der Absorber mit zunehmender Frequenz steigt, folgt daraus, dass für höhere Frequenzen tendenziell eine Erhöhung des Abstands vorteilhaft ist, um eine optimale Feldqualität zu erzielen.

Für tiefere Frequenzen ergeben sich andere Randbedingungen. Der Fernfeldradius ist generell kleiner. Gleichzeitig ist die Reflektionsdämpfung der Absorber geringer. Dies kann durch kleinere Reflektionswinkel α (also im Ergebnis durch eine Verringerung des Abstands) kompensiert werden. Somit ergibt sich für niedrige Frequenzen ein vergleichsweise geringerer optimaler Abstand zwischen AUT und Sendeantenne.

Die geschilderte Frequenzabhängigkeit macht es notwendig, den Abstand zwischen Sendeantenne und AUT je nach Messfrequenz gezielt einzustellen. Bei einer vollständigen Absorberkammer können die Antennen jedoch nicht frei bewegt werden, da der Boden zwischen Sendeantenne und Empfangsantenne mit Absorbern belegt ist. Deshalb sind für unterschiedliche Messfrequenzen aufwendige manuelle Umbauten erforderlich.

US5532704A offenbart eine Vorrichtung zum Positionieren von Antennen, wobei die Vorrichtung eine Anordnung aufweist, die einen Antennenträgermast aufweist, der beweglich in einer Reserve montiert ist, die zwischen einer bestimmten absorbierenden Wand der Messkammer und der angrenzenden Wand der Hülle der Kammer vorgesehen ist; der Mast durchläuft die jeweilige Wand über einen zugehörigen Schlitz, um sich in die Messkammer zu erstrecken, wobei jede Antenne so montiert ist, dass sie entlang des Mastes gleitet, ohne mechanisch mit einer anderen vom Mast getragenen Antenne zu interferieren, wodurch es möglich wird, eine gewünschte Antenne an einem Ort zu positionieren, während die anderen Antennen im Reservoir hinter der oben genannten speziellen Wand eingefahren werden.

M.J. Alexander et al:"A national measurement good practice guide no.73 Calibration and use of antennas, focusing on EMC applications" offenbart ein Schienensystem im Boden der Kammer und zwei Wagen mit niedrigem Reflexionsgrad. Durch diese Anordnung kann der Abstand zwischen den Antennen eingestellt werden, während die Ausrichtung konstant bleibt.

US20060261821A1 offenbart eine Vorrichtung zum Messen eines Lesebereichs zwischen einem RFID-Tag und einem Lesegerät, das eine Antennenkammer mit einfacher Mobilität und Erweiterbarkeit bereitstellt, und genau bestimmt, ob das RFID-Tag gemäß der Position gelesen wird, und das Muster einer Antenne durch genaues Messen einer Feldstärke je nach Abstand und Winkel zwischen RFID-Tag und Lesegerät analysiert.

Es ist Aufgabe der Erfindung, eine Antennenmesskammer mit vollständiger Auskleidung an Absorptionselementen zu schaffen, die bei geringen Umrüstzeiten Messungen innerhalb eines breiten Frequenzspektrums ermöglicht.

Diese Aufgabe wird mit der Antennenmesskammer gemäß Patentanspruch 1 gelöst. Vorteilhafte Ausführungen der Erfindung sind Gegenstand von Unteransprüchen.

Die erfindungsgemäße Antennenmesskammer mit variabler Antennenentfernung ist auf ihren inneren Begrenzungsflächen vollständig mit Absorbern ausgekleidet. Sie umfasst separate Träger für die zu prüfende Antenne und für eine Sendeantenne als Gegenstelle. Darüber hinaus ist ihr Boden als doppelter Boden, bestehend aus unterem und parallelem oberen Boden, ausgebildet zur unsichtbaren Kabelführung der Versorgungs- und Steuerleitungen der Antennen.

Zur variablen Einstellung der Distanz zwischen den beiden Antennen ist der Träger für eine der beiden Antennen als beweglicher Schlitten ausgebildet, welcher auf dem unteren der beiden Böden des doppelten Bodens bewegbar ist und der den oberen Boden mit darauf befindlicher Auskleidung durchdringt.

Der Schlitten besteht aus einem nichtleitenden Material, insbesondere einem Kunststoffmaterial und seine Bewegung kann ferngesteuert werden. Die Durchdringung des Schlittens durch die Auskleidung erfolgt entlang der Grenze zwischen benachbarten Absorbern, so dass Lage und Ausrichtung der Absorber durch die Bewegung des Schlittens nicht gestört wird. Durch die Flexibilität des Absorbermaterials schließt sich der durch den Schlitten entstehende Schlitz vor und hinter selbigem sofort wieder. Dadurch bleibt die Wirkung der Absorber unverändert erhalten.

Vorteilhaft weist der Schlitten einen u-förmigen Querschnitt auf, mit zwei, die Auskleidung durchdringenden Seitenwänden und einer Basisftäche zur Aufnahme einer Antenne. Die Seitenwände weisen vorteilhaft abgerundete Kanten zur Erleichterung der Bewegung zwischen den Absorbern auf. Dadurch wird insbesondere eine Verletzung oder dauerhafte Verformung des flexiblen Absorbermaterials vermieden.

Der Abstand der Seitenwände entspricht vorteilhaft der Kantenlänge eines oder mehrerer Absorber, so dass sich die Seitenwände ausschließlich zwischen aneinander angrenzenden Reihen von Absorbern bewegen können.

In einer weiteren Ausführung befinden sich zwei parallele Schienen auf dem unteren Boden des doppelten Bodens, auf denen der Schlitten beweglich gelagert ist. Im Falle der vorstehend beschriebenen Ausführung des Schlittens wird dieser an seinen beiden Seitenwänden auf die Schienen aufgesetzt. Die Bewegung des Schlittens entlang der Schienen kann mit einem Linearantrieb erfolgen.

In einer besonders vorteilhaften Ausführung sind die HF-Kabel versteckt zur Antenne geführt, wobei insbesondere die Kabelführung im Messumfeld versteckt ausgeführt ist. Das wird insbesondere dadurch erreicht, dass die HF-Signalkabel für die auf dem Schlitten vorgesehene Antenne im Inneren der Seitenwand des Schlittens sowie im doppelten Boden der Messkammer verlegt sind.

Vorteilhaft weisen die Seitenwände des Schlittens eine Dicke zwischen 5 und 20 mm auf, insbesondere zwischen 10 und 15mm.

Vorteilhaft ermöglicht die Antennenmesskammer Messungen im Frequenzbereich zwischen 1 kHz bis maximal 30GHz. Insbesondere ist die Kammer eingerichtet für Messungen zwischen 100 MHz und 18GHz. Besonders vorteilhaft kann dabei für Radaranwendungen der Bereich 400 MHz bis 6 GHz für Messungen eingesetzt werden.

Mit der erfindungsgemäßen Antennenmesskammer lassen sich erhebliche Kosteneinsparungen und deutlich reduzierte Umrüstzeiten realisieren. Die Veränderung des Abstands der Antennen ist ohne aufwendige Umbaumaßnahmen, wie manueller Ein- und Ausbau der auf dem Boden angeordneten Absorber, möglich. Mit der durch die Erfindung eröffneten Möglichkeit, die Bewegung einer Antenne ferngesteuert vorzunehmen, wird der Zugang des Bedienpersonals zur Antennenmesskammer auf das absolute Mindestmaß reduziert, z.B. Austausch der Antennen, Reparaturen etc.

Mit der Bewegung des Schlittens kann somit für alle Frequenzbänder eine optimierte Feldqualität innerhalb der Messkammer sichergestellt werden, ohne dass aufwendige manuelle Umbauten notwendig wären.

Die Erfindung wird anhand eines konkreten Ausführungsbeispiels unter Bezugnahme auf Fig. 1 bis 3 näher erläutert. Es zeigen:

Fig. 1    den Aufbau einer gattungsgemäßen Messkammer,

Fig. 2    einen Ausschnitt der erfindungsgemäßen Antennenmesskammer in Querschnittsdarstellung,

Fig. 3    eine Schnittdarstellung entlang der Linie A-A aus Fig.2 mit Detailansicht der Seitenwand eines Schlittens, umgeben von Absorbern.

Wie bereits in der Beschreibungseinleitung erläutert, ist in Fig. 1 der Grundriss einer gattungsgemäßen Antennenmesskammer 1 dargestellt. Diese weist elektrisch gut leitfähige Außenwände 10 auf, die den Innenraum der Kammer von elektromagnetischer Strahlung schützen. Damit wird erreicht, dass keine Störsignale die Messwerte verfälschen. Man erkennt auf der linken Seite die zu prüfende Antenne (AUT) 30 und auf der rechten Seite die Sendeantenne 20 als Gegenstelle. Zudem sind mit Pfeilen 21 Ausbreitungsrichtungen des von der Sendeantenne 20 abgestrahlten elektromagnetischen Signals angedeutet. Der Winkel α definiert den Reflektionswinkel der Strahlung an den Seitenwänden der Kammer. Die Messkammer ist als vollständige Absorberkammer ausgeführt, d.h. es befinden sich an allen innenliegenden Begrenzungsflächen der Kammer durchgängig und lückenlos Absorber 11 (aus Gründen der Übersichtlichkeit wurde auf die Darstellung der Absorber auf dem Boden verzichtet).

Abhängig von der verwendeten Signalfrequenz ist es notwendig, den Abstand zwischen den beiden Antennen 20, 30 zu verringern oder zu vergrößern. Um möglichst viel Spielraum für die Einstellung des Abstands zwischen AUT 30 und der Sendeantenne 20 zu haben, ist der Grundriss der Messkammer rechteckig gewählt.

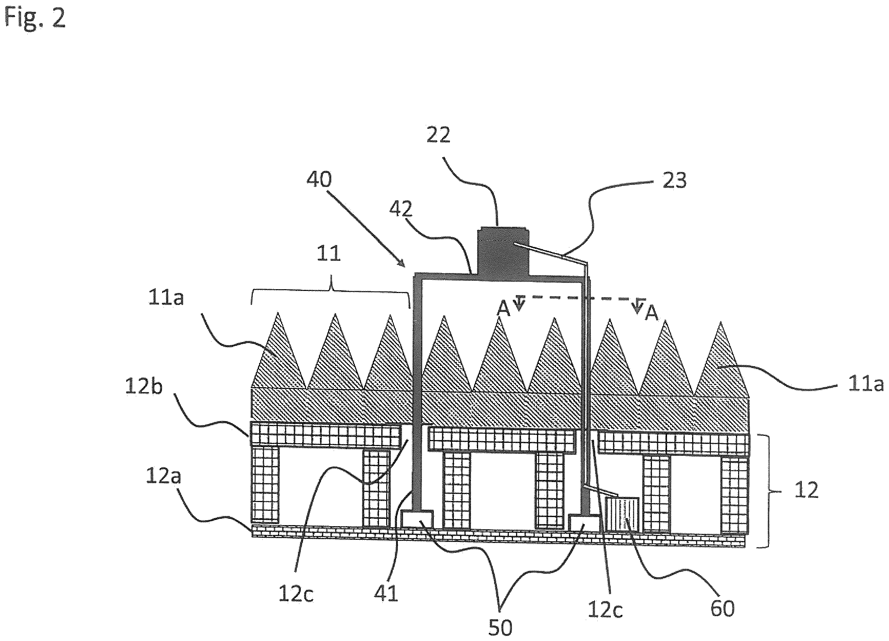

Die erfindungsgemäße Antennenmesskammer 1 ist in Fig. 2 ausschnittsweise in einer vertikalen Schnittdarstellung widergegeben (Schnitt parallel zur kurzen Seite der Messkammer). Man erkennt den doppelten Boden 12, umfassend unteren 12a und oberen Boden 12b. Auf dem oberen Boden 12b sind durchgehend und lückenlos Absorber 11 aufgebracht. Dabei handelt es sich um flexible, mattenartige Objekte, die jeweils ein festes Raster pyramidenförmiger Strukturen aufweisen und mit denen sämtliche Innenflächen der Messkammer ausgekleidet sind. Ein solcher Absorber 11 hat typischerweise einen quadratischen Grundriss mit eine Kantenlänge von z.B. 60 cm. In dem gezeigten Beispiel weist ein Absorber 11 in einer Dimension genau drei solche Pyramiden 11a auf. Handelsüblich sind insbesondere Absorber mit 20x20, 12x12, 7x7 cm etc. Auch Absorber, die nur eine einzige Pyramide aufweisen, sind gebräuchlich. Die Absorber werden üblicherweise aus einem Schaumstoffblock geschnitten.

Der obere Boden 12b weist, wie Fig. 2 ebenfalls zeigt, zwei parallele Ausschnitte 12c auf (siehe auch Fig. 1), die die Bewegungsrichtung eines Schlittens 40 parallel zur langen Seite der Messkammer vorgeben (die Bewegungsrichtung des Schlittens 40 steht senkrecht zur Papierebene der Fig. 2). Dieser Schlitten 40 dient als Träger für die Sendeantenne 20. Bezugsziffer 22 bezeichnet eine Halterung für diese Antenne, welche auf einer Basisplatte 42 des Schlittens 40 angeordnet ist. Der Schlitten 40 ist hier als u-förmiger Tisch mit zwei Seitenwänden 41 ausgeführt, wobei im gezeigten Beispiel der Abstand der Seitenwände 41 der Kantenlänge eines Absorbers 11 entspricht. Die Seitenwände 41 durchdringen den oberen Boden 12b an seinen zueinander parallelen Ausschnitten 12c.

Der Schlitten 40 bewegt sich in der hier gezeigten Ausführung über zwei parallele Schienen 50 auf dem unteren Boden 12a, in welchen die Seitenwände 41 des Schlittens 40 geführt werden. Der Antrieb des Schlittens 40 kann als Linearantrieb ausgeführt sein. Beispielsweise kann dies über eine Zahnradtrieb erfolgen oder über einen Radantrieb. Besonders vorteilhaft erfolgt die Kabelführung (HF-Leitungen, sowie Steuer- und Versorgungsleitungen) zum Schlitten 40 im doppelten Boden unter den Absorbern 11 (vorteilhaft mittels einer beweglichen Energieführungskette 60), damit jegliche Störung innerhalb der Antennenmesskammer 1 vermieden wird. Von dort können die Leitungen vorteilhaft innerhalb der Seitenwand 41 des Schlittens 40 zur Antenne 20 geführt werden. Insgesamt werden insbesondere alle HF-Kabel 23 versteckt zur Antenne geführt, damit keinerlei Störung durch die Kabelführungen verursacht wird.

Der Schlitten 40 ist aus einem Dielektrikum, insbesondere Kunststoff hergestellt. Der verwendete Kunststoff ist derart auszuwählen, dass die Feldverteilung in der Absorberkammer möglichst wenig beeinflusst wird. Für Frequenzen bis zu ca. 1 GHz kann dies durch eine geringe Dielektrizitätskonstante näherungsweise erreicht werden. Geeignete Materialien sind z.B. PP-Polypropylen ($\varepsilon_r$ ca. 2,3) und für mechanische höhere Belastungen z.B. PEEK-Polyetheretherketon ($\varepsilon_r$ ca. 3,1 - 3,3). Für Frequenzen > 1 GHz können zusätzliche konstruktive Maßnahmen vorteilhaft sein, wobei z.B. die Flächen des Kunststoffschlittens 40 soweit möglich ebenfalls mit Absorbermatten versehen werden.

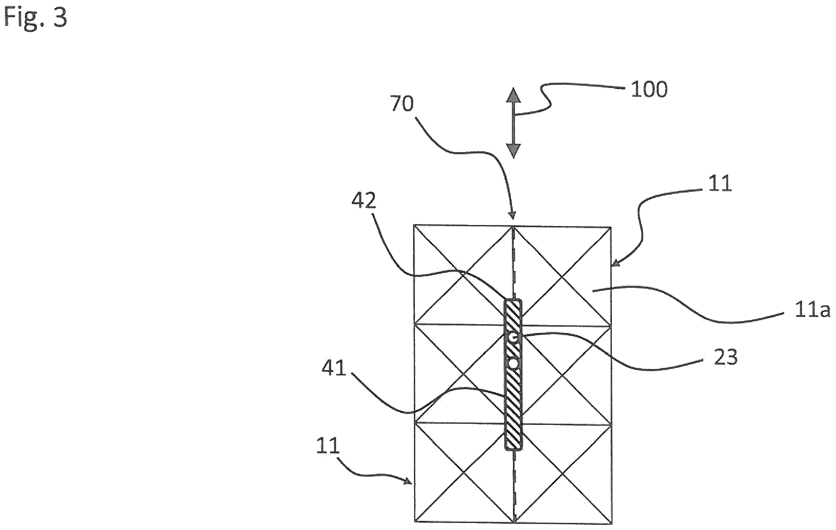

Wie insbesondere im Beispiel der Fig. 2 zu erkennen ist, ist die Dicke der Seitenwände 41 des Kunststoffschlittens 40 gering und beträgt vorteilhaft 5 bis 20mm. Die Seitenwände 41 des Kunststoffschlittens 40 befinden sich jeweils genau zwischen zwei benachbarten Absorbern 11. In Fig. 3 sieht man aus der Vogelperspektive (Schnitt A-A in Fig. 2) eine Seitenwand 41 des Schlittens 40, wobei der gezeigte Detailausschnitt rechts und links davon jeweils nur einen Teil eines Absorbers 11 erfasst. Die Bewegungsrichtung des Schlittens 40 ist mit Bezugsziffer 100 gekennzeichnet. Die Seitenwand 41 des Schlittens 40 bewegt sich entlang der Grenze 70 zwischen zwei benachbarten Absorbern 11. Die Absorber 11 bilden ein regelmäßiges Raster und die Bewegung des Schlittens 40 bzw. seiner Seitenwände 41 erfolgt entlang der Rasterlinien. Man erkennt in Fig. 2 außerdem die vorteilhafte Kabelführung des HF-Kabels 23 innerhalb der Seitenwand 41.

Bei der Bewegung der Seitenwände 41 müssen diese das flexible Absorbermaterial temporär verdrängen. Hierbei hilft das schlanke Design der Seitenwände 41 wie bereits oben beschrieben. Darüber hinaus können die Seitenwände 41 des Schlittens 40 vorteilhaft abgerundete Kanten 42 zur Erleichterung seiner Bewegung und zur Verhinderung nicht reversibler Formänderungen an den Absorbern 11 aufweisen. Der Schlitten 40 bewegt sich immer entlang der Grenzlinie 70 zweier benachbarter Absorber 11. Die sich aus der Bewegung ergebenden Schlitze vor und hinter der Seitenwand 41 schließen sich auf Grund der Flexibilität des Materials der Absorber 11 selbstständig, so dass die Absorberwirkung nicht beeinträchtigt wird.

Die Seitenwand 41 kann eine rechteckige (einfachste Bauform) oder ovale Grundform aufweisen, wobei bei der rechteckigen Ausführung anstelle von abgerundeten Kanten 42 auch spitz zulaufende Enden der Seitenwände 41 möglich sind. Scharfe Kanten, die das Absorbermaterial verletzten könnten, sind aber in jedem Fall zu vermeiden. Die Gestaltung und Ausführung der Seitenwand 41 muss das lückenlose Wiederverschließen der Absorberzwischenräume, wie bereits erläutert, ermöglichen.

**Patentansprüche**

1. Antennenmesskammer (1) zur Vermessung von Antenneneigenschaften von HF-Antennen, mit folgenden Merkmalen:

   - einer vollständigen Auskleidung mit einer Mehrzahl von Absorbern (11) an ihren innenliegenden Begrenzungsflächen,
   - separaten Trägern für eine zu prüfende Antenne (30) und für eine Sendeantenne (20),
   - einem doppelten Boden (12) zur unsichtbaren Kabelführung der Versorgungs- und Steuerleitungen der Antennen,
   **dadurch gekennzeichnet, dass**
   der Träger für eine der beiden Antennen als beweglicher Schlitten (40) ausgebildet ist, welcher auf dem unteren (12a) der beiden Böden (12a , 12b) des doppelten Bodens (12) bewegbar ist und der den oberen Boden (12b) mit darauf befindlicher Auskleidung durchdringt, und dass der Schlitten (40) einen u-förmigen Querschnitt mit zwei, die Auskleidung durchdringenden Seitenwänden (41) und einer Basis (42) zur Aufnahme einer Antenne aufweist, und dass die HF-Signalkabel (23) für die auf dem Schlitten (40) vorgesehene Antenne im Inneren der Seitenwand (41) des Schlittens (40) verlegt sind.

2. Antennenmesskammer nach Anspruch 1, **dadurch gekennzeichnet, dass** die Durchdringung des Schlittens (40) durch die Auskleidung zwischen aneinander angrenzenden Absorbern (11) erfolgt.

3. Antennenmesskammer (1) nach Anspruch 1, **dadurch gekennzeichnet, dass** die Seitenwände (41) des Schlittens (40) abgerundete Kanten (42) zur Erleichterung der Bewegung zwischen den Absorbern (11) aufweisen.

4. Antennenmesskammer (1), nach einem der Ansprüche 1 bis 3, **dadurch gekennzeichnet, dass** der Abstand der Seitenwände (41) der Kantenlänge eines Absorbers (11) oder mehrerer Absorber (11) entspricht.

5. Antennenmesskammer (1) nach einem der vorangehenden Ansprüche, **dadurch gekennzeichnet, dass** sich zur Bewegung des Schlittens(40) zwei parallele Schienen (50) auf dem unteren Boden (12a) des doppelten Bodens (12) befinden, wobei die Bewegung des Schlittens (40) entlang der Schienen (50) mit einem Linearantrieb erfolgt.

6. Antennenmesskammer (1) nach einem der vorangehenden Ansprüche, **dadurch gekennzeichnet, dass** die HF-Signalkabel (23) der Antennen innerhalb des doppelten Bodens (12) verlegt sind.

**7.** Antennenmesskammer (1) nach einem der vorangehenden Ansprüche, **dadurch gekennzeichnet, dass** die Dicke der Seitenwände (41) des Schlittens (40) zwischen 5 und 20 mm beträgt.

**8.** Antennenmesskammer (1) nach einem der vorangehenden Ansprüche, **dadurch gekennzeichnet, dass** der bewegliche Schlitten(40) fernsteuerbar ist.

**9.** Antennenmesskammer (1) nach einem der vorangehenden Ansprüche, **dadurch gekennzeichnet, dass** der Schlitten (40) aus einem Kunststoffmaterial besteht.

**10.** Antennenmesskammer (1) nach einem der vorangehenden Ansprüche, **dadurch gekennzeichnet, dass** sie einen rechteckigen Grundriss aufweist.


**Claims**

**1.** Antenna measuring chamber (1) for measuring the antenna properties of RF antennas, comprising the following features:

- a complete lining having a plurality of absorbers (11) on their inner boundary surfaces,
- separate supports for an antenna to be tested (30) and for a transmitting antenna (20),
- a double floor (12) for invisible cable routing for the supply and control lines of the antennas, **characterized in that**
the support for one of the two antennas is designed as a movable carriage (40) which is movable on the lower (12a) of the two floors (12a, 12b) of the double floor (12) and which penetrates the upper floor (12b) having the lining located thereon, and **in that** the carriage (40) has a U-shaped cross section having two side walls (41) which penetrate the lining and a base (42) for receiving an antenna, and **in that** the RF signal cables (23) for the antenna provided on the carriage (40) are laid inside the side wall (41) of the carriage (40).

**2.** Antenna measuring chamber according to claim 1, **characterized in that** the carriage (40) penetrates through the lining between adjacent absorbers (11).

**3.** Antenna measuring chamber (1) according to claim 1, **characterized in that** the side walls (41) of the carriage (40) have rounded edges (42) in order to facilitate the movement between the absorbers (11).

**4.** Antenna measuring chamber (1) according to any of claims 1 to 3, **characterized in that** the distance between the side walls (41) corresponds to the edge length of an absorber (11) or a plurality of absorbers (11).

**5.** Antenna measuring chamber (1) according to any of the preceding claims, **characterized in that** two parallel rails (50) are located on the lower floor (12a) of the double floor (12) for moving the carriage (40), the carriage (40) being moved along the rails (50) by a linear drive.

**6.** Antenna measuring chamber (1) according to any of the preceding claims, **characterized in that** the RF signal cables (23) of the antennas are laid inside the double floor (12).

**7.** Antenna measuring chamber (1) according to any of the preceding claims, **characterized in that** the thickness of the side walls (41) of the carriage (40) is between 5 and 20 mm.

**8.** Antenna measuring chamber (1) according to any of the preceding claims, **characterized in that** the movable carriage (40) is remotely controllable.

**9.** Antenna measuring chamber (1) according to any of the preceding claims, **characterized in that** the carriage (40) consists of a plastics material.

**10.** Antenna measuring chamber (1) according to any of the preceding claims, **characterized in that** said chamber has a rectangular outline.


**Revendications**

**1.** Chambre de mesure d'antennes (1) destinée à mesurer des propriétés d'antennes HF, comportant les caractéristiques suivantes :

- un habillage complet comportant une pluralité d'absorbeurs (11) sur ses surfaces de délimitation internes,
- des supports séparés pour une antenne à contrôler (30) et pour une antenne d'émission (20),
- un double fond (12) destiné au passage invisible de câbles des lignes d'alimentation et de commande des antennes, **caractérisée**
**en ce que** le support pour l'une des deux antennes est conçu sous la forme d'un chariot mobile (40), lequel est mobile sur le fond inférieur (12a) des deux fonds (12a, 12b) du double fond (12) et traverse le fond supérieur (12b) et l'habillage se trouvant sur celui-ci, et **en ce que** le chariot (40) comprend une section transversale en forme de U comportant deux parois latérales (41) traversant l'habillage et une base (42) destinée à recevoir une antenne, et **en ce que** les câbles de signaux HF (23) pour l'antenne prévue sur le chariot (40) sont placés à l'intérieur de la paroi latérale (41) du chariot (40).

2. Chambre de mesure d'antennes selon la revendication 1, **caractérisée en ce que** la traversée de l'habillage par le chariot (40) se produit entre des absorbeurs adjacents (11).

3. Chambre de mesure d'antennes (1) selon la revendication 1, **caractérisée en ce que** les parois latérales (41) du chariot (40) présentent des bords arrondis (42) destinés à faciliter le déplacement entre les absorbeurs (11).

4. Chambre de mesure d'antennes (1) selon l'une quelconque des revendications 1 à 3, **caractérisée en ce que** la distance entre les parois latérales (41) correspond à la longueur de bord d'un absorbeur (11) ou de plusieurs absorbeurs (11).

5. Chambre de mesure d'antennes (1) selon l'une quelconque des revendications précédentes, **caractérisée en ce que** deux rails parallèles (50) sont agencés sur le fond inférieur (12a) du double fond (12) pour le déplacement du chariot (40), le déplacement du chariot (40) le long des rails (50) se produisant à l'aide d'un entraînement linéaire.

6. Chambre de mesure d'antennes (1) selon l'une quelconque des revendications précédentes, **caractérisée en ce que** les câbles de signaux HF (23) des antennes sont placés à l'intérieur du double fond (12).

7. Chambre de mesure d'antennes (1) selon l'une quelconque des revendications précédentes, **caractérisée en ce que** l'épaisseur des parois latérales (41) du chariot (40) est comprise entre 5 et 20 mm.

8. Chambre de mesure d'antennes (1) selon l'une quelconque des revendications précédentes, **caractérisée en ce que** le chariot mobile (40) est télécommandable.

9. Chambre de mesure d'antennes (1) selon l'une quelconque des revendications précédentes, **caractérisée en ce que** le chariot (40) est constitué d'une matière plastique.

10. Chambre de mesure d'antennes (1) selon l'une quelconque des revendications précédentes, **caractérisée en ce qu'**elle comprend un plan de base rectangulaire.

Fig. 1

Fig. 2

Fig. 3

EP 3 455 640 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5532704 A

- US 20060261821 A1

**In der Beschreibung aufgeführte Nicht-Patentliteratur**

- **M.J. ALEXANDER et al.** *A national measurement good practice guide no.73 Calibration and use of antennas, focusing on EMC applications*